# EUROPEAN PATENT SPECIFICATION

(11) **EP 4 110 033 B1**
(45) Date of publication and mention of the grant of the patent: **02.04.2025**
(21) Application number: 20919657.5
(22) Date of filing: 19.02.2020
(51) Int. Cl.: H05K 13/04, H05K 13/08

(54) **COMPONENT MOUNTING MACHINE**
KOMPONENTENMONTAGEMASCHINE
MACHINE DE MONTAGE DE COMPOSANTS

(43) Date of publication of application: 28.12.2022
(73) Proprietor: Fuji Corporation, Chiryu-shi, Aichi 472-8686 (JP)
(72) Inventor: ITO, Mikine, Chiryu-shi, Aichi 472-8686 (JP)
(74) Representative: Grünecker Patent- und Rechtsanwälte PartG mbB
(86) International application number: PCT/JP2020/006596
(87) International publication number: WO 2021/166133

(56) References cited:
- WO-A1-2016/059679
- WO-A1-2016/063328
- WO-A1-2018/138815
- JP-A- 2007 189 041
- US-A1- 2017 311 493

## Description

### Technical Field

The present specification discloses a component mounting machine.

### Background Art

Conventionally, there has been known a component mounting machine that simultaneously picks up multiple electronic components from multiple tape feeders by a transfer head including multiple suction nozzles and mounts the electronic components on a board (for example, refer to Patent Literature 1). The component mounting machine detects in advance a positional deviation amount of a component stop position in each tape feeder and stores the positional deviation amount as stop positional correction data. Then, when the component is picked up by the transfer head, the component mounting machine controls a tape feeding mechanism based on the stop positional correction data to perform a position alignment for matching the component stop position with a component suction position by the suction nozzle of the transfer head.

US 2017/311493 A1 relates to a component pickup position correction system for a rotary head type component mounter. In particular, a head moving mechanism is provided with a rotary head 24 having multiple suction nozzles that pick up a component. The rotary head rotates about its central axis, lowers the suction nozzle at a specified stopping position of the revolution path to pick up a component, and corrects the direction of a component picked up by the suction nozzle. Component pickup positions are corrected by searching in memory for measurement data of the positions of the multiple suction nozzles and calculating the rotation angle and movement amount in the XY directions or the rotary head required to move to the component pickup positions of the suction nozzles, based on the positons of the suction nozzles and on positions of ideal pickup points along two straight lines extending in the tape feeding direction. With regard to the order of picking up the components, sixteen suction nozzles are rotated such that two suction nozzles are positioned on the straight lines, and the leading components of the component supply tape are fed to pickup positions. The tape feeding amount can be calculated from the current positions of the leading components of the tape feeders.

JP 2007 189041 A relates to a component mounting device with a head having a plurality of suction nozzles. A residual amount deviation of the Y-axis makes a feed direction move the components tape forwards or backwards.

### Patent Literature

Patent Literature 1: JP-A-2005-5288

### Summary of the Invention

### Technical Problem

As described above, Patent Literature 1 describes correcting the positional deviation in a case where the component stop position, at which the component fed by the tape feeding mechanism of the tape feeder stops, has a positional deviation. However, Patent Literature 1 does not mention a case where a positional deviation occurs in a feeding direction of the component toward the multiple suction nozzles.

A main object of the present disclosure is to provide a component mounting machine capable of appropriately executing pickup of components even in a case where positional deviation occurs in a feeding direction of the components in multiple pickup members.

### Solution to Problem

The present disclosure employs the following means in order to achieve the above-mentioned main object.

The scope of the invention is defined by the independent claim.

According to the component mounting machine of the present disclosure, it is possible to appropriately execute the pickup of the components even in a case where the positional deviation occurs in the feeding direction of the components in the multiple pickup members.

### Brief Description of Drawings

[Fig. 1] Fig. 1 is a schematic configuration view of a component mounting machine.
[Fig. 2] Fig. 2 is a schematic configuration view of a feeder.
[Fig. 3] Fig. 3 is a partially enlarged view of the vicinity of a component supply position of the feeder.
[Fig. 4] Fig. 4 is a schematic configuration view of a mounting head.
[Fig. 5] Fig. 5 is an explanatory view for explaining an arrangement of nozzle holders.
[Fig. 6] Fig. 6 is a block diagram illustrating an electrical connection relationship of a mounting control device of a component mounting machine.
[Fig. 7] Fig. 7 is a flowchart illustrating an example of simultaneous suction processing.
[Fig. 8] Fig. 8 is an explanatory view for explaining a Y-axis direction positional deviation amount.
[Fig. 9] Fig. 9 is an explanatory diagram illustrating an example of the Y-axis direction positional deviation amount stored in a storage device.
[Fig. 10] Fig. 10 is a flowchart illustrating an example of component supply processing.
[Fig. 11] Fig. 11 is a schematic configuration view of a mounting head according to a modification example.

### Description of Embodiments

Next, an embodiment of the present disclosure will be described with reference to the drawings.

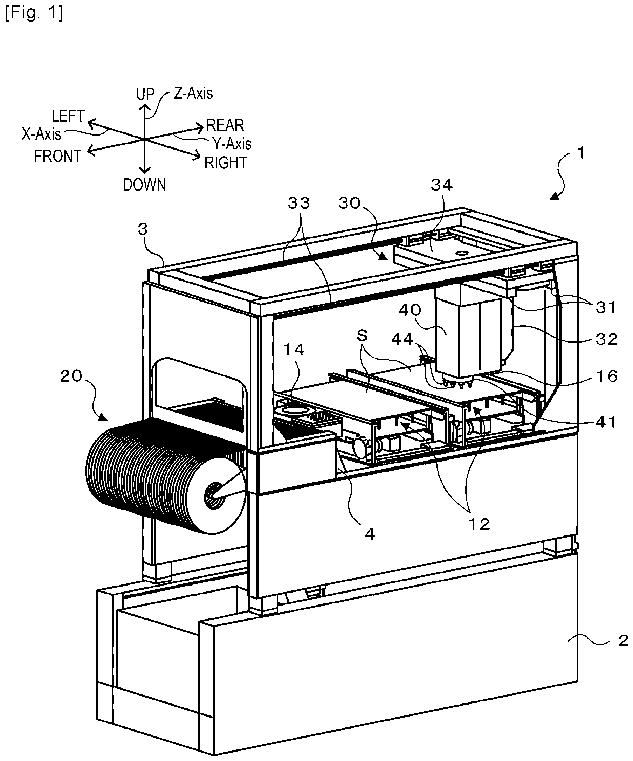

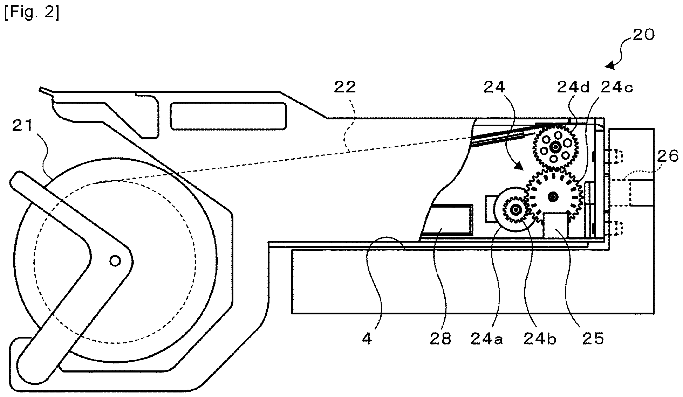

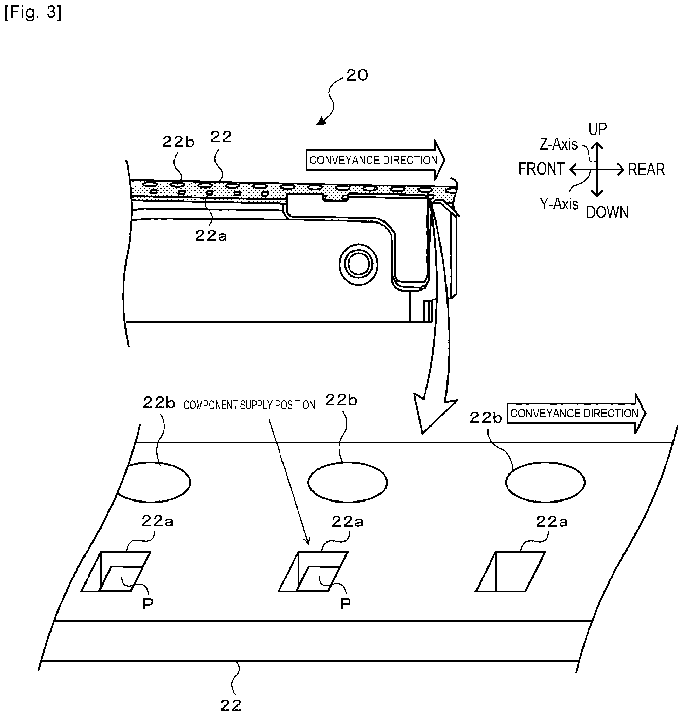

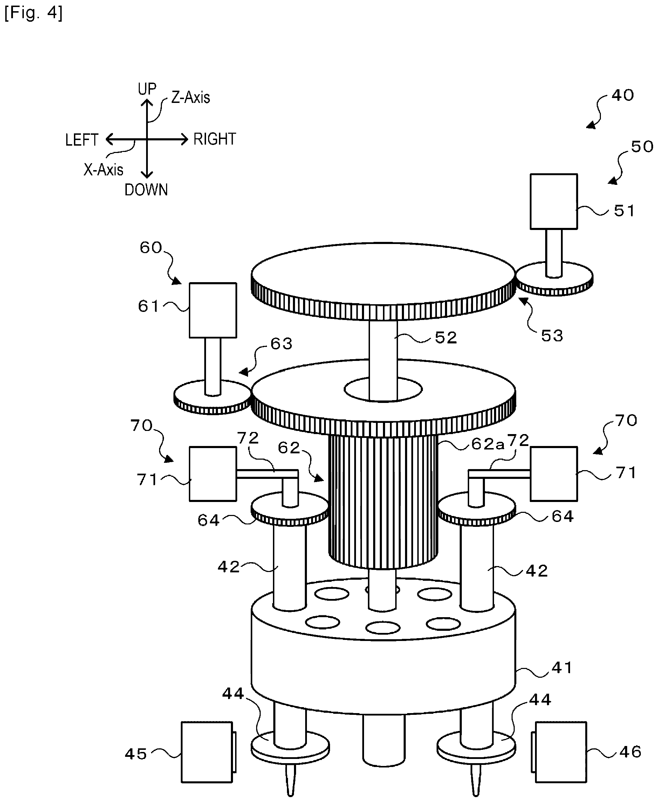

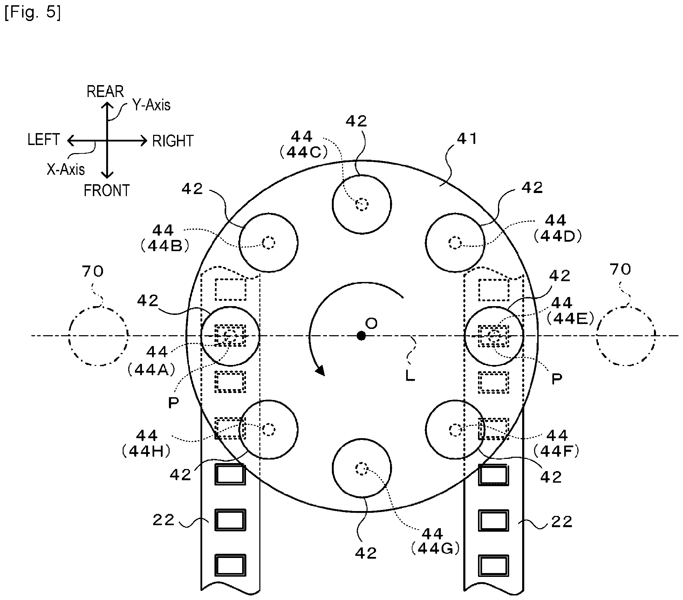

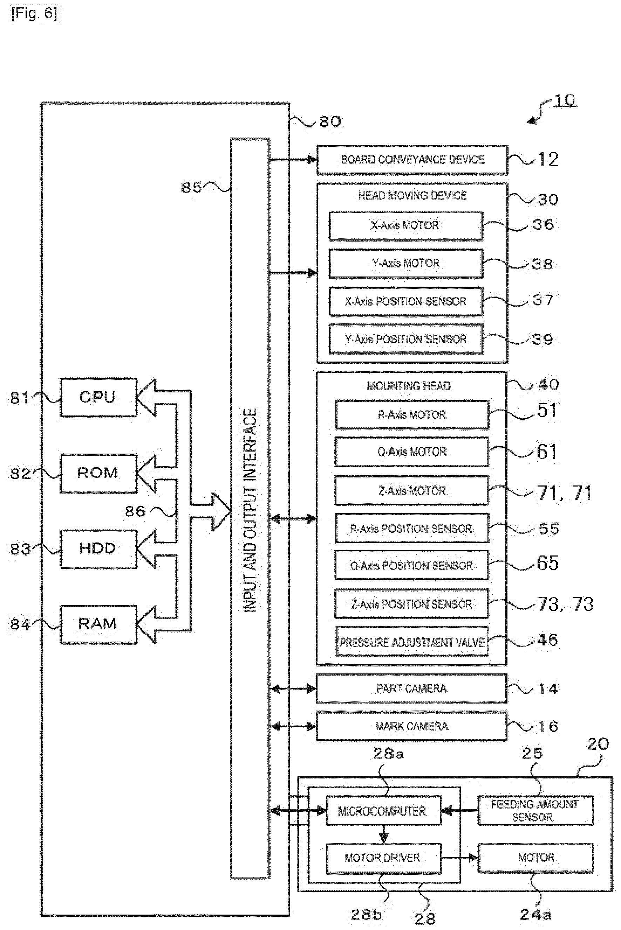

Fig. 1 is a schematic configuration view of a component mounting machine. Fig. 2 is a schematic configuration view of a feeder. Fig. 3 is a partially enlarged view of the vicinity of a component supply position of the feeder. Fig. 4 is a schematic configuration view of a mounting head. Fig. 5 is an explanatory view for explaining an arrangement of the nozzle holders. Fig. 6 is an explanatory diagram illustrating an electrical connection relationship of a mounting control device of the component mounting machine. The left-right direction in Fig. 1 is the X-axis direction, the front (front)-rear (back) direction is the Y-axis direction substantially orthogonal to the X-axis direction, and the up-down direction is the Z-axis direction substantially orthogonal to the X-axis direction and the Y-axis direction (horizontal plane).

As illustrated in Fig. 1, component mounting machine 1 includes housing 3 that is installed on base 2, board conveyance device 12, feeder 20, head moving device 30, mounting head 40, and mounting control device 80 (refer to Fig. 6). In addition to these, component mounting machine 1 also includes parts camera 14, mark camera 16, and the like. Parts camera 14 is provided between feeder 20 and board conveyance device 12 for imaging component P picked up by suction nozzle 44 of mounting head 40 from below. Mark camera 16 is provided on mounting head 40 for imaging and reading a reference mark attached to board S from above.

Board conveyance device 12 has a pair of conveyor belts that are provided at intervals in the front-rear direction of Fig. 1 and spanned in the X-axis direction (left-right direction). Board S is conveyed from the left to the right in the drawing by the conveyor belt of board conveyance device 12.

As illustrated in Fig. 1, feeder 20 is attached to feeder base 4 provided in front of housing 3 so as to be arranged in the left-right direction (X-axis direction). As illustrated in Fig. 2, feeder 20 is configured as a tape feeder including reel 21, tape feeding mechanism 24, connector 26, and feeder control device 28. Tape 22 is wound around reel 21. As illustrated in Fig. 3, tape 22 is formed with cavity 22a and sprocket hole 22b at predetermined intervals along a longitudinal direction thereof. Component P is accommodated in cavity 22a.

Tape feeding mechanism 24 includes feeding motor 24a configured as a stepping motor, driving gear 24b provided on a rotation axis of feeding motor 24a, transmission gear 24c meshing with driving gear 24b, and sprocket 24d having sprocket teeth meshing with transmission gear 24c on an outer peripheral surface. Tape feeding mechanism 24 engages the sprocket teeth of sprocket 24d with sprocket hole 22b formed in tape 22, and intermittently rotates sprocket 24d by the driving of feeding motor 24a, thereby drawing tape 22 from reel 21 and sequentially feeding tape 22 to the component supply position (refer to Fig. 3). Component P accommodated in tape 22 is protected by a film covering a surface of tape 22. Then, the film of component P is peeled off in front of the component supply position to be in an exposed state at the component supply position, thereby capable of being picked up by suction nozzle 44.

As illustrated in Fig. 6, feeder control device 28 includes a microcomputer 28a incorporating a CPU, a ROM, a RAM, and the like, and motor driver 28b serving as a drive circuit of feeding motor 24a. Microcomputer 28a receives a detection signal from feeding amount sensor 25 that detects the feeding amount of tape 22 by detecting the rotational displacement of transmission gear 24c, and outputs a pulse signal for driving feeding motor 24a to motor driver 28b. Motor driver 28b generates a drive current based on the input pulse signal and outputs the same to feeding motor 24a. When sprocket 24d is rotated by a driving force from feeding motor 24a via transmission gear 24c, tape 22 engaged with sprocket 24d is fed to the component supply position.

Head moving device 30 moves mounting head 40 in the XY-axis direction (front-rear left-right direction), and includes X-axis slider 32 and Y-axis slider 34, as illustrated in Fig. 1. X-axis slider 32 is supported by a pair of upper and lower X-axis guide rails 31 provided on a front surface of Y-axis slider 34 so as to extend in the X-axis direction (left-right direction), and is movable in the X-axis direction by the driving of X-axis motor 36 (refer to Fig. 6). Y-axis slider 34 is supported by a pair of left and right Y-axis guide rails 33 provided on an upper stage portion of housing 3 so as to extend in the Y-axis direction (front-rear direction), and is movable in the Y-axis direction by the driving of Y-axis motor 38 (refer to Fig. 6). The position of X-axis slider 32 in the X-axis direction is detected by X-axis position sensor 37 (refer to Fig. 6), and the position of Y-axis slider 34 in the Y-axis direction is detected by Y-axis position sensor 39 (refer to Fig. 6). Mounting head 40 is attached to X-axis slider 32. Therefore, mounting head 40 is movable along the XY-plane (horizontal plane) by driving and controlling head moving device 30 (X-axis motor 36 and Y-axis motor 38).

As illustrated in Fig. 4, mounting head 40 includes head main body 41, multiple nozzle holders 42 (eight in the embodiment), multiple suction nozzles 44 (eight in the embodiment), R-axis driving device 50, Q-axis driving device 60, and two Z-axis driving devices 70.

Head main body 41 is a rotation body that can be rotated by R-axis driving device 50. Nozzle holders 42 are arranged at predetermined angular intervals (in the embodiment, at 45° intervals) on the same circumference about the rotation axis (center axis) of head main body 41, and are supported so as to be freely liftable and lowerable by head main body 41. Suction nozzle 44 is mounted on a distal end portion of nozzle holder 42. Suction nozzle 44 has a suction port at a distal end, and picks up component P by a negative pressure supplied from a negative pressure source (not illustrated) to the suction port via pressure adjustment valve 46 (refer to Fig. 6). Suction nozzle 44 is detachable from nozzle holder 42, and is replaced with a nozzle suitable for the pickup of component P according to the type of component P to be picked up.

R-axis driving device 50 turns (revolves) multiple nozzle holders 42 (multiple suction nozzles 44) in the circumferential direction around a center axis of head main body 41. As illustrated in Fig. 4, R-axis driving device 50 includes R-axis motor 51, R-axis 52 extending in an axis direction from center axis of head main body 41, and transmission gear 53 that transmits the rotation of R-axis motor 51 to R-axis 52. R-axis driving device 50 causes head main body 41 to rotate by causing R-axis motor 51 to rotationally drive R-axis 52 by way of transmission gears 53. Each nozzle holder 42 turns in circle (revolves) in the circumferential direction together with corresponding suction nozzle 44 as a result of the rotation of head main body 41. In addition, R-axis driving device 50 includes R-axis position sensor 55 (refer to Fig. 6) for detecting the rotational position of R-axis 52, that is, the turning position of each nozzle holder 42 (suction nozzle 44).

Q-axis driving device 60 causes each nozzle holder 42 (each suction nozzle 44) to rotate (spin) around its own center axis. As illustrated in Fig. 4, Q-axis driving device 60 includes Q-axis motor 61, cylindrical gear 62, transmission gear 63, and Q-axis gear 64. Cylindrical gear 62 is inserted into the inside thereof so that R-axis 52 is coaxial and relatively rotatable, so that external teeth 62a of spur teeth are formed on an outer peripheral surface thereof. Transmission gear 63 transmits the rotation of Q-axis motor 61 to cylindrical gear 62. Q-axis gear 64 is provided on an upper portion of each nozzle holder 42 and slidably meshes with external teeth 62a of cylindrical gear 62 in the Z-axis direction (up-down direction). Q-axis driving device 60 rotationally drives cylindrical gear 62 by Q-axis motor 61 via transmission gear 63, so that each Q-axis gear 64 meshing with external teeth 62a of cylindrical gear 62 can be collectively rotated in the same direction. Each nozzle holder 42 rotates (spins) about its own center axis together with suction nozzle 44 by the rotation of Q-axis gear 64. In addition, Q-axis driving device 60 includes Q-axis position sensor 65 (refer to Fig. 6) for detecting the rotational position of Q-axis gear 64, that is, the rotational position of each nozzle holder 42 (suction nozzle 44).

Each Z-axis driving device 70 is configured to be able to individually lift and lower nozzle holder 42 at two portions on a turning (revolving) track of nozzle holder 42. Suction nozzle 44 mounted on nozzle holder 42 lifts and lowers together with nozzle holder 42. In the present embodiment, as illustrated in Fig. 5, each Z-axis driving device 70 is disposed so as to be able to lift and lower two nozzle holders 42 (suction nozzles 44) that pass through center axis O of head main body 41 and are located on line L parallel to an arrangement direction (X-axis direction) of feeder 20. In the present embodiment, each Z-axis driving device 70 is capable of lifting and lowering a set of suction nozzles 44A and 44E, a set of suction nozzles 44B and 44F, a set of suction nozzles 44C and 44G, and a set of suction nozzles 44D and 44H among eight suction nozzles 44A to 44H mounted on eight nozzle holders 42 arranged in the circumferential direction. Since eight suction nozzles 44A to 44H constituting these are arranged on the same circumference about center axis O of head main body 41, each nozzle set has substantially the same nozzle-to-nozzle distance.

As illustrated in Fig. 4, each Z-axis driving device 70 includes Z-axis slider 72 and Z-axis motor 71 that lifts and lowers Z-axis slider 72. In addition, each Z-axis driving device 70 also includes Z-axis position sensor 73 (refer to Fig. 6) for detecting a lifting and lowering position of corresponding Z-axis slider 72, that is, a lifting and lowering position of a corresponding nozzle holder 42 (suction nozzle 44). Each Z-axis driving device 70 drives Z-axis motor 71 to lift and lower corresponding Z-axis slider 72, thereby contacting nozzle holder 42 located below Z-axis slider 72 to integrally lift and lower nozzle holder 42 with suction nozzle 44. Two Z-axis driving devices 70 may lift and lower Z-axis slider 72 using a linear motor as Z-axis motor 71, or may lift and lower Z-axis slider 72 using a rotation motor and a feeding screw mechanism. Each Z-axis driving device 70 may lift and lower Z-axis slider 72 by using an actuator such as an air cylinder instead of Z-axis motor 71. As described above, mounting head 40 according to the embodiment includes two Z-axis driving devices 70 each capable of individually lifting and lowering nozzle holder 42 (suction nozzle 44), and can individually perform the suction operation of component P by suction nozzle 44 using each Z-axis driving device 70. In addition, as illustrated in Fig. 5, mounting head 40 of the embodiment supplies two components P from corresponding feeder 20 so as to be arranged in the X-axis direction (left-right direction) at approximately the same interval as two suction nozzles 44 that can be lifted and lowered by two Z-axis driving devices 70, so that two suction nozzles 44 can be simultaneously lowered to pick up two components P (simultaneous suction operation).

As illustrated in Fig. 6, mounting control device 80 is configured as a microprocessor centered on CPU 81, and includes ROM 82, HDD 83, RAM 84, input and output interface 85, and the like in addition to CPU 81. These constituent elements are connected to one another via bus 86. Various detection signals from X-axis position sensor 37, Y-axis position sensor 39, R-axis position sensor 55, Q-axis position sensor 65, Z-axis position sensor 73, and the like are input to mounting control device 80. In addition, image signals and the like from parts camera 14 and mark camera 16 are also input to mounting control device 80 via the input and output interface 85. On the other hand, various control signals are output from mounting control device 80 to feeder 20, board conveyance device 12, X-axis motor 36, Y-axis motor 38, R-axis motor 51, Q-axis motor 61, Z-axis motor 71, pressure adjustment valve 46, parts camera 14, mark camera 16, and the like.

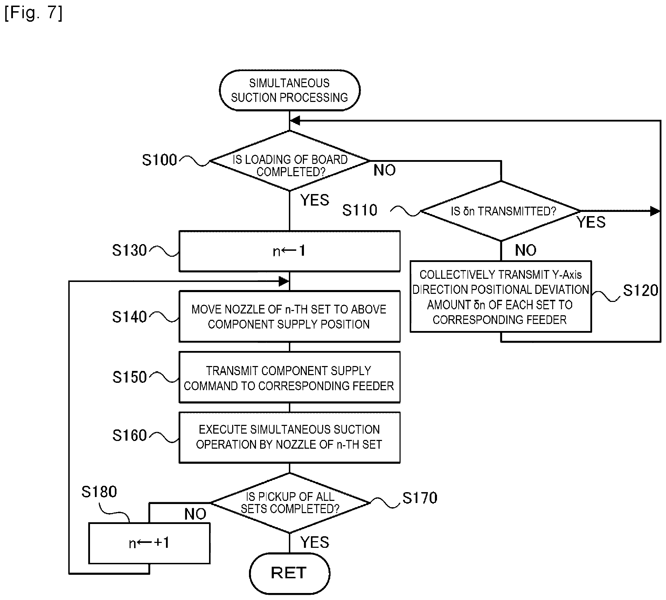

Next, an operation of component mounting machine 1 of the embodiment configured as described above, particularly, the simultaneous suction operation described above will be described. Fig. 7 is a flowchart illustrating an example of simultaneous suction processing executed by CPU 81 of mounting control device 80.

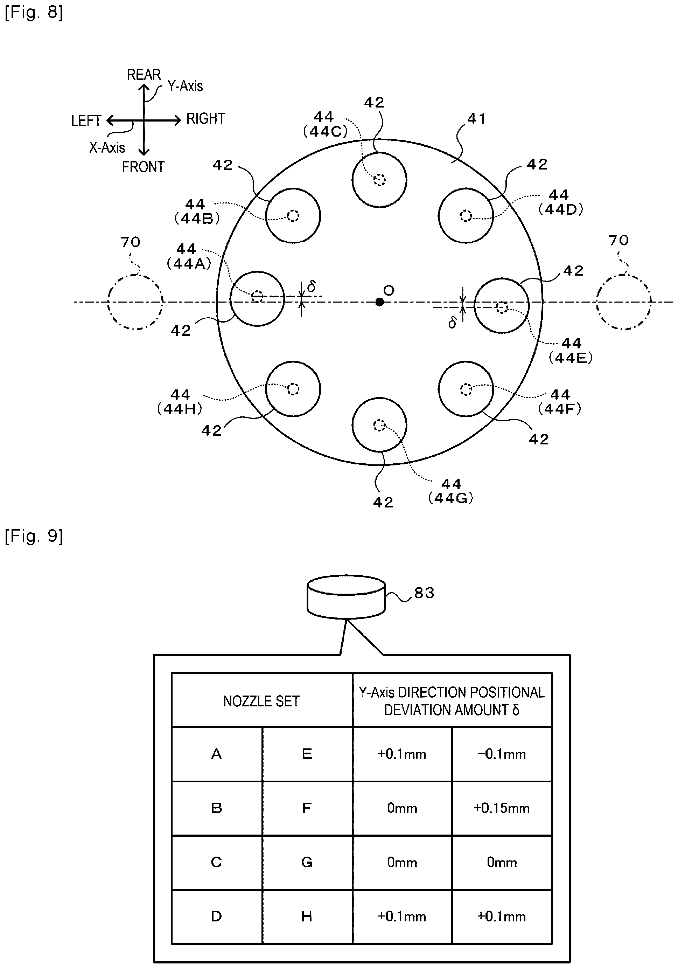

When the simultaneous suction processing is executed, CPU 81 of mounting control device 80 first determines whether loading of board S by board conveyance device 12 is completed (S100). If it is determined that the loading of board S is not completed, CPU 81 determines whether Y-axis direction positional deviation amount δn of each suction nozzle 44 has been transmitted (S110), and if not transmitted, collectively transmits Y-axis direction positional deviation amount δn of each suction nozzle 44 to each feeder 20 (feeder control device 28) that supplies component P to be simultaneously picked up to each suction nozzle 44 (S120). Fig. 8 is an explanatory view for explaining the Y-axis direction positional deviation amount. As illustrated in the drawing, Y-axis direction positional deviation amount δn is a positional deviation amount in the Y-axis direction (feeding direction of component P) of the distal end (suction port) of suction nozzle 44 that performs the suction operation with respect to line L passing through center axis O of head main body 41 and parallel to the X-axis direction (arrangement direction of feeder 20). Y-axis direction positional deviation amount δn, which will be described later, is used as a correction value when target tape feeding amount αn is set in feeder 20 that supplies components P to be simultaneously picked up. The transmission of Y-axis direction positional deviation amount δn is stored HDD 83 (storage device) by measuring Y-axis direction positional deviation amount δn for each suction nozzle 44 in advance, and is performed by transmitting stored Y-axis direction positional deviation amount δn to feeder control device 28 of corresponding feeder 20 at the timing during the loading of board S. Fig. 9 is an explanatory diagram illustrating an example of the Y-axis direction positional deviation amount stored in the storage device. In the present embodiment, among eight suction nozzles 44A to 44H (refer to Fig. 5), suction nozzles 44A, 44B, 44C, and 44D pick up components P supplied from one feeder 20 of two feeders 20 that supply components P to be simultaneously picked up. In addition, among eight suction nozzles 44A to 44H, suction nozzles 44E, 44F, 44G, and 44H pick up component P supplied from other feeder 20 of two feeders 20. Therefore, Y-axis direction positional deviation amounts δn of suction nozzles 44A, 44B, 44C, and 44D are collectively transmitted to feeder control device 28 of the one feeder 20. Y-axis direction positional deviation amounts δn of suction nozzles 44E, 44F, 44G, and 44H are collectively transmitted to feeder control device 28 of other feeder 20. In S110, if it is determined that Y-axis direction positional deviation amount δn has been transmitted, CPU 81 skips S120 and waits for the loading of board S to be completed.

When it is determined that the loading of board S is completed, CPU 81 initializes variable n to value 1 (S130), and controls head moving device 30 so that an n-th set of two suction nozzles 44 moves to above the component supply position to which two components P to be simultaneously picked up are supplied (S140). Subsequently, CPU 81 transmits a component supply command to feeder control devices 28 of two feeders 20 that supply two components P to be simultaneously picked up (S150). CPU 81 performs the simultaneous suction operation of causing two suction nozzles 44 of the n-th set to simultaneously pick up components P (S160). The simultaneous suction operation is performed by controlling two Z-axis driving devices 70 so that two suction nozzles 44 of the n-th set lower, and controlling pressure adjustment valve 46 so that a negative pressure is supplied to the suction ports of two suction nozzles 44. If the simultaneous suction operation is performed, CPU 81 determines whether the pickup of components P to all the sets of suction nozzles 44 is completed (S170). If it is determined that the pickup of all the sets is not completed, CPU 81 increments variable n by value 1 (S180), returns to S140, and repeats the simultaneous suction operation of causing two suction nozzles 44 of the next n-th set to pick up components P. If it is determined that the pickup of all the sets is completed, CPU 81 terminates the component pickup processing. When the component pickup processing is terminated, CPU 81 shifts to component mounting processing (not illustrated).

When the processing shifts to the component mounting processing, CPU 81 controls head moving device 30 so that mounting head 40 moves above parts camera 14, and images component P picked up by suction nozzle 44 by parts camera 14 from below. Subsequently, CPU 81 processes the captured image to calculate the positional deviation amount (suction deviation amount) of component P picked up by each suction nozzle 44, and corrects the mounting position of board S based on the calculated positional deviation amount. Next, CPU 81 controls head moving device 30 so that component P picked up by suction nozzle 44 to be mounted this time is located above the corrected mounting position. Then, CPU 81 controls corresponding Z-axis driving device 70 so that suction nozzle 44 lowers, and controls pressure adjustment valve 46 so that the supply of the negative pressure to the suction port of suction nozzle 44 is canceled. Therefore, component P is mounted on the mounting position of board S. In addition, if any component P that has not been mounted remains in any of multiple suction nozzles 44 of mounting head 40, CPU 81 repeats the mounting operation of mounting suction nozzle 44 to be mounted next to the mounting position of board S until all components P are mounted.

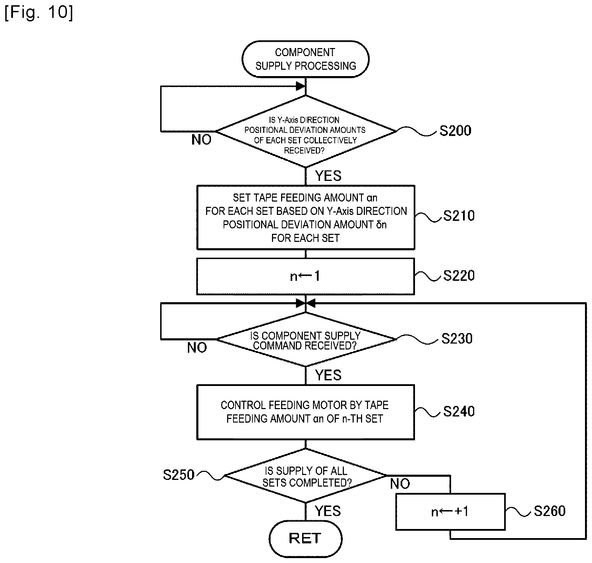

Next, an operation of feeder 20 for supplying components P to be simultaneously picked up will be described. Fig. 10 is a flowchart illustrating an example of component supply processing executed by microcomputer 28a (CPU) of feeder control device 28.

In the component supply processing, microcomputer 28a first waits for collective reception of Y-axis direction positional deviation amounts δn of all the sets of suction nozzles 44 collectively transmitted by mounting control device 80 in S120 of the simultaneous suction processing described above (S200). If it is determined that Y-axis direction positional deviation amounts δn of all the sets are collectively received, microcomputer 28a sets target tape feeding amount αn for each set using Y-axis direction positional deviation amount δn for each set as the correction value (S210). Target tape feeding amount αn for each set is set by correcting reference feeding amount β common to each set for supplying component P to the component supply position using Y-axis direction positional deviation amount δn for each set as the correction value. Specifically, target tape feeding amount αn for each set is set by adding Y-axis direction positional deviation amount δn of the corresponding set to reference feeding amount β.

Next, microcomputer 28a initializes variable n to value 1 (S220), and waits for receiving the component supply command transmitted from mounting control device 80 in S150 of the simultaneous suction processing described above (S230). If it is determined that the component supply command is received, microcomputer 28a drives and controls feeding motor 24a so that tape 22 is fed by target tape feeding amount αn of the n-th set (S240). Therefore, component P accommodated in tape 22 is fed to the component supply position. Since target tape feeding amount αn is reference feeding amount β when Y-axis direction positional deviation amount δn is value 0, component P accommodated in tape 22 is exactly located at the component suction position by feeding tape 22 by target tape feeding amount αn. On the other hand, when Y-axis direction positional deviation amount δn is a positive predetermined value (when the distal end of suction nozzle 44 deviates behind in the component feeding direction), tape 22 is fed by target tape feeding amount αn, so that component P accommodated in tape 22 is located behind (back) the component supply position by the predetermined value. In addition, when Y-axis direction positional deviation amount δn is a negative predetermined value (when the distal end of suction nozzle 44 deviates ahead in the component feeding direction), tape 22 is fed by target tape feeding amount αn, so that component P accommodated in tape 22 is located ahead (front) of the component supply position by the predetermined value. Therefore, even if there is a positional deviation of suction nozzle 44 in the component feeding direction (Y-axis direction), component P can be picked up at a correct position by using suction nozzle 44.

Microcomputer 28a determines whether the supply of components P is completed in all the sets (S250). If it is determined that the supply of component P is not completed in all the sets, microcomputer 28a increments variable n by value 1 (S260), returns to S230, and repeats the operation of supplying component P of the next n-th set by driving and controlling feeding motor 24a by target tape feeding amount αn of the next n-th set when the next component supply command is received. Then, in S250, if it is determined that the supply of component P has been completed for all the sets, microcomputer 28a terminates the component supply processing.

Here, a correspondence relationship between main elements of the embodiment and main elements of the present disclosure described in the scope of claims will be described. That is, suction nozzle 44 of the embodiment corresponds to the pickup member of the present disclosure, mounting head 40 corresponds to the head, head moving device 30 corresponds to the moving device, feeder 20 corresponds to the feeder, and mounting control device 80 corresponds to the control device. In addition, board conveyance device 12 corresponds to the board conveyance device. In addition, head main body 41 corresponds to the rotation body, and mounting head 40 corresponds to the rotary head.

The present disclosure is not limited to the embodiments described above, and it is needless to say that various forms can be implemented within the technical scope of the present disclosure.

For example, in the above-described embodiments, mounting control device 80 transmits Y-axis direction positional deviation amount δn of all the sets to feeder 20 so that feeder 20 (feeder control device 28) collectively receives the same during the conveyance (during loading) of board S. However, mounting control device 80 may transmit Y-axis direction positional deviation amount δn of all the sets to feeder 20 so that feeder 20 (feeder control device 28) collectively receives the same during the mounting operation. That is, mounting control device 80 may transmit the same to feeder 20 so that feeder 20 collectively receives the same at a timing other than during the simultaneous suction operation.

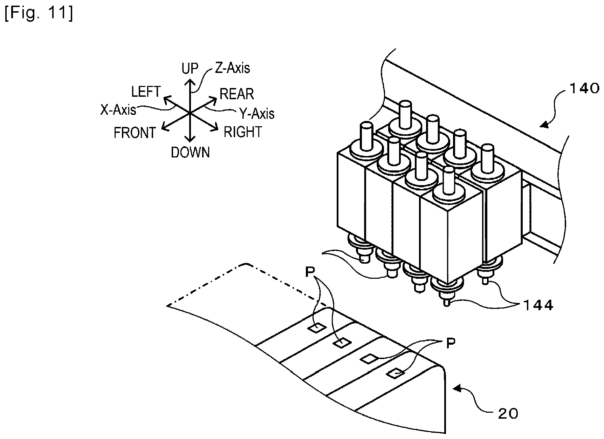

In the above-described embodiments, mounting head 40 is configured as a rotary type head in which multiple nozzle holders 42 are arranged in the circumferential direction with respect to head main body 41. However, as illustrated in Fig. 11, mounting head 40 may include a parallel type mounting head 140 having multiple sets of multiple suction nozzles 144 arranged at the same pitch as multiple components P supplied from feeder 20 along the arrangement direction (X-axis direction) of feeder 20, and respectively individually liftable and lowerable.

In the above embodiment, mounting head 40 includes two Z-axis driving devices 70 that individually lift and lower the two nozzle holders 42 (suction nozzle 44) at predetermined positions. However, mounting head 40 may include three or more Z-axis driving devices, or may be configured to simultaneously lower three or more suction nozzles by three or more Z-axis driving devices, so that three or more components P are simultaneously picked up by each suction nozzle.

As described above, the gist of the present disclosure is a component mounting machine as defined in the independent claim 1.

According to the component mounting machine of the present disclosure, it is possible to appropriately execute the pickup even in a case where the positional deviation occurs in the feeding direction of the component in the multiple pickup members. Here, the head may have multiple sets of the multiple pickup members, and multiple feeders may be provided as the feeder.

In such a component mounting machine according to the present disclosure, the component mounting machine may further include a board conveyance device configured to convey a board, and the predetermined timing may be a timing during conveyance of the board. Alternatively, the predetermined timing may be a timing during a mounting operation of mounting the component picked up by the pickup member on the board. The feeder collectively receives the correction values for the number of sets at a timing different from the timing at which the components are to be supplied to set the target feeding amount, whereby it is possible to suppress the occurrence of a delay in the supply of the components due to a communication delay or the like.

In the component mounting machine of the present disclosure, the head may be a rotary head having a rotation body and having multiple sets of the multiple pickup members on the same circumference about a rotation axis of the rotation body.

Further, in the component mounting machine of the present disclosure, the component mounting machine further includes a moving device for moving the head, the multiple pickup members is arranged to be liftable and lowerable at a predetermined interval in an orthogonal direction orthogonal to the predetermined direction, the feeder includes multiple feeders arranged at approximately the same interval as the predetermined interval in the orthogonal direction, and the control device executes a simultaneous suction operation of controlling the moving device and the head so that the components fed from the multiple feeders are picked up by the multiple pickup members at substantially the same time. According to such a configuration, in the component mounting machine including a mounting head that has the multiple pickup members capable of picking up the components supplied from the multiple feeders at substantially the same time, it is possible to appropriately execute simultaneous pickup even in a case where the positional deviation occurs in the feeding direction (predetermined direction) of the components in the multiple pickup members. In this case, the control device collectively transmits the correction values to the multiple feeders at a timing other than during the execution of the simultaneous suction operation as the predetermined timing.

### Industrial Applicability

The present disclosure can be applied to a manufacturing industry of a component mounting machine or the like.

### Reference Signs List

1 component mounting machine, 2 base, 3 housing, 4 feeder base, 12 board conveyance device, 14 parts camera, 16 mark camera, 20 feeder, 21 reel, 22 tape, 22a cavity, 22b sprocket hole, 24 tape feeding mechanism, 24a feeding motor, 24b driving gear, 24c transmission gear, 24d sprocket, 25 feeding amount sensor, 26 connector, 28 feeder control device, 28a microcomputer, 28b motor driver, 30 head moving device, 31 X-axis guide rail, 32 X-axis slider, 33 Y-axis guide rail, 34 Y-axis slider, 36 X-axis motor, 37 X-axis position sensor, 38 Y-axis motor, 39 Y-axis position sensor, 40, 140 mounting head, 41 head main body, 42 nozzle holder, 44, 44A to 44H, 144 suction nozzle, 46 pressure adjustment valve, 50 R-axis driving device, 51 R-axis motor, 52 R-axis, 53 transmission gear, 55 R-axis position sensor, 60 Q-axis driving device, 61 Q-axis motor, 62 cylindrical gear, 62a external teeth, 64 Q-axis gear, 65 Q-axis position sensor, 70 Z-axis driving device, 71 Z-axis motor, 72 Z-axis slider, 73 Z-axis position sensor, 80 mounting control device, 81 CPU, 82 ROM, 83 HDD, 84 RAM, 85 input and output interface, 86 bus, P component, S board

## Claims

1. A component mounting machine (1) configured to pick up a component (P) and mount the component (P) on a board (S), the component mounting machine (1) comprising:
a head (40, 140) having a plurality of sets of pickup members (44A-H, 144), wherein each set comprises a plurality of pickup members (44A-H, 144) arranged so as to be liftable and lowerable at a predetermined interval in an orthogonal direction orthogonal to a predetermined direction;
a moving device for moving the head (40, 140);
a plurality of feeders (20) configured to receive correction values for the plurality of sets of pickup members (44A-H, 144), set a target feeding amount for each of the plurality of sets based on the received correction values, and sequentially feed components for the plurality of sets in the predetermined direction with each set target feeding amount, wherein the plurality of feeders (20) are arranged at approximately the same interval as the predetermined interval in the orthogonal direction; and
a control device (80) configured to acquire a positional deviation amount of the multiple pickup members (44A-H, 144) in the predetermined direction for each set and to execute a simultaneous suction operation of controlling the moving device and the head (40, 144) so that the components fed from the plurality of feeders (20) are picked up by the plurality of pickup members (44A-H, 144) at approximately the same time,
**characterized in that**
the control device (80) is configured to transmit, as the correction values for the plurality of sets, the positional deviation amount for the plurality of sets to the plurality of feeders (20) so that the plurality of feeders (20) collectively receive the correction values for the plurality of sets at a predetermined timing, wherein the positional deviation amount is measured in advance for each of the plurality of pickup members (44A-H, 144) and stored in a storage device, and the control device (80) is configured to transmit the stored positional deviation amount for each of the plurality of pickup members (44A-H, 144) to a feeder control device (28) of a corresponding one of the plurality of feeders (20), and wherein the predetermined timing is a timing during conveyance of the board (S) or a timing during a mounting operation of mounting the component (P) picked up by the pickup member (44A-H, 144) on the board (S).

2. The component mounting machine (1) according to claim 1, further comprising:
a board conveyance device (12) configured to convey the board (S).

3. The component mounting machine (1) according to claim 1 or 2,
wherein the head (40) is a rotary head having a rotation body (41) and having the plurality of sets of the pickup members (44A-H, 144) on the same circumference about a rotation axis of the rotation body.

4. The component mounting machine (1) according to any one of claims 1 to 3,
wherein the control device (80) is configured to collectively transmit the correction values to the multiple feeders (20) at a timing other than during the execution of the simultaneous suction operation as the predetermined timing.

## Patentansprüche

1. Maschine (1) zum Montieren von Bauteilen, die so ausgeführt ist, dass sie ein Bauteil (P) aufnimmt und das Bauteil (P) auf einer Platine (S) montiert, wobei die Maschine (1) zum Montieren von Bauteilen umfasst:
einen Kopf (40, 140), der eine Vielzahl von Gruppen von Aufnahmeelementen (44A-H, 144) aufweist, wobei jede Gruppe eine Vielzahl von Aufnahmeelementen (44A-H, 144) umfasst, die so angeordnet sind, dass sie in einem vorgegebenen Intervall in einer orthogonalen Richtung orthogonal zu einer vorgegebenen Richtung angehoben und abgesenkt werden können;
eine Bewegungseinrichtung zum Bewegen des Kopfes (40, 140);
eine Vielzahl von Zuführeinrichtungen (20), die so ausgeführt sind, dass sie Korrekturwerte für die Vielzahl von Gruppen von Aufnahmeelementen (44A-H, 144) empfangen, eine Ziel-Zuführstrecke für jede der Vielzahl von Gruppen auf Basis der empfangenen Korrekturwerte Festlegen und Bauteile für die Vielzahl von Gruppen in der vorgegebenen Richtung mit jeder festgelegten Ziel-Zuführstrecke sequenziell zuführen, wobei die Vielzahl von Zuführeinrichtungen (20) in ungefähr dem gleichen Intervall wie dem vorgegebenen Intervall in der orthogonalen Richtung angeordnet sind; sowie
eine Steuerungseinrichtung (80), die so ausgeführt ist, dass sie ein Positions-Abweichungsmaß der mehreren Aufnahmeelemente (44A-H, 144) in der vorgegebenen Richtung für jede Gruppe erfasst und einen simultanen Ansaugvorgang zum Steuern der Bewegungseinrichtung sowie des Kopfes (40, 144) so ausführt, dass die Bauteile von der Vielzahl von Zuführeinrichtungen (20) ungefähr zur gleichen Zeit von der Vielzahl von Aufnahmeelementen (44A-H, 144) aufgenommen werden,
**dadurch gekennzeichnet, dass**
die Steuerungseinrichtung (80) so ausgeführt ist, dass sie als die Korrekturwerte für die Vielzahl von Gruppen das Positions-Abweichungsmaß für die Vielzahl von Gruppen der Vielzahl von Zuführeinrichtungen (20) so sendet, dass die Vielzahl von Zuführeinrichtungen (20) gemeinsam die Korrekturwerte für die Vielzahl von Gruppen zu einem vorgegebenen Zeitpunkt empfangen, wobei das Positions-Abweichungsmaß im Voraus für jedes der Vielzahl von Aufnahmeelementen (44A-H, 144) gemessen und in einer Speicherungseinrichtung gespeichert wird, und die Steuerungseinrichtung (80) so ausgeführt ist, dass sie das gespeicherte Positions-Abweichungsmaß für jedes der Vielzahl von Aufnahmeelementen (44A-H, 144) zu einer Zuführungs-Steuerungseinrichtung (28) einer entsprechenden der Vielzahl von Zuführeinrichtungen (20) sendet, und
wobei der vorgegebene Zeitpunkt ein Zeitpunkt bei Transport der Platine (S) oder ein Zeitpunkt während eines Montagevorgangs zum Montieren des von dem Aufnahmeelement (44A-H, 144) aufgenommenen Bauteils (P) auf der Platine (S) ist.

2. Maschine (1) zum Montieren von Bauteilen nach Anspruch 1, die des Weiteren umfasst: eine Platinen-Transporteinrichtung (12), die zum Transportieren der Platine (S) ausgeführt ist.

3. Maschine (1) zum Montieren von Bauteilen nach Anspruch 1 oder 2,
wobei der Kopf (40) ein Drehkopf ist, der einen Drehkörper (41) aufweist und die Vielzahl von Gruppen der Aufnahmeelemente (44A-H, 144) an dem gleichen Umfang um eine Drehachse des Drehkörpers herum aufweist.

4. Maschine (1) zum Montieren von Bauteilen nach einem der Ansprüche 1 bis 3,
wobei die Steuerungseinrichtung (80) so ausgeführt ist, dass sie die Korrekturwerte gemeinsam zu einem anderen Zeitpunkt als während der Ausführung des simultanen Ansaugvorgangs als dem vorgegebenen Zeitpunkt zu den mehreren Zuführeinrichtungen (20) sendet.

## Revendications

1. Machine de montage de composants (1) configurée pour prélever un composant (P) et monter le composant (P) sur une carte (S), la machine de montage de composants (1) comprenant :
une tête (40, 140) ayant une pluralité d'ensembles d'éléments de prélèvement (44A-H, 144), dans laquelle chaque ensemble comprend une pluralité d'éléments de prélèvement (44A-H, 144) agencés afin de pouvoir être soulevés et abaissés à un intervalle prédéterminé dans un sens orthogonal qui est orthogonal par rapport à un sens prédéterminé ;
un dispositif de déplacement pour déplacer la tête (40, 140) ;
une pluralité de dispositifs d'alimentation (20) configurés pour recevoir des valeurs de correction pour la pluralité d'ensembles d'éléments de prélèvement (44AH, 144), définir une quantité d'alimentation cible pour chacun de la pluralité d'ensembles sur la base des valeurs de correction reçues, et alimenter séquentiellement des composants pour la pluralité d'ensembles dans le sens prédéterminé avec chaque quantité d'alimentation cible d'ensemble, dans laquelle la pluralité des dispositifs d'alimentation (20) sont agencés sous approximativement le même intervalle que l'intervalle prédéterminé dans le sens orthogonal ; et
un dispositif de commande (80) configuré pour acquérir une quantité d'écart de position des multiples éléments de prélèvement (44A-H, 144) dans le sens prédéterminé pour chaque ensemble et pour exécuter une opération d'aspiration simultanée de commande du dispositif de déplacement et de la tête (40, 144) de sorte que les composants alimentés depuis la pluralité de dispositifs d'alimentation (20) sont prélevés par la pluralité d'éléments de prélèvement (44A-H, 144) approximativement au même moment,
**caractérisée en ce que**
le dispositif de commande (80) est configuré pour transmettre, comme les valeurs de correction pour la pluralité d'ensembles, la quantité d'écart de position pour la pluralité d'ensembles à la pluralité de dispositifs d'alimentation (20) de sorte que la pluralité de dispositifs d'alimentation (20) reçoit collectivement les valeurs de correction pour la pluralité d'ensembles sous un minutage prédéterminé, dans laquelle la quantité d'écart de position est mesurée à l'avance pour chacun de la pluralité d'éléments de prélèvement (44A-H, 144) et stockée dans un dispositif de stockage, et le dispositif de commande (80) est configuré pour transmettre la quantité d'écart de position stockée pour chacun de la pluralité d'éléments de prélèvement (44A-H, 144) à un dispositif de commande de dispositif d'alimentation (28) de l'un correspondant de la pluralité de dispositifs d'alimentation (20), et
dans laquelle le minutage prédéterminé est un minutage durant un transport de la carte (S) ou un minutage durant une opération de montage du montage du composant (P) prélevé par l'élément de prélèvement (44AH, 144) sur la carte (S).

2. Machine de montage de composants (1) selon la revendication 1, comprenant en outre :
un dispositif de transport de carte (12) configuré pour transporter la carte (S).

3. Machine de montage de composants (1) selon la revendication 1 ou 2,
dans laquelle la tête (40) est une tête rotative ayant un corps de rotation (41) et ayant la pluralité d'ensembles d'éléments de prélèvement (44A-H, 144) sur la même circonférence autour d'un axe de rotation du corps de rotation.

4. Machine de montage de composants (1) selon l'une quelconque des revendications 1 à 3,
dans laquelle le dispositif de commande (80) est configuré pour transmettre collectivement les valeurs de correction aux multiples dispositifs d'alimentation (20) sous un minutage autre que durant l'exécution de l'opération d'aspiration simultanée comme minutage prédéterminé.
